# EUROPEAN PATENT APPLICATION

(11) **EP 4 155 254 A1**
(43) Date of publication of application: **29.03.2023**
(21) Application number: 21198884.5
(22) Date of filing: 24.09.2021
(51) Int. Cl.: B81C 1/00, B81B 3/00

(54) **METHODS FOR STIMULUS-SENSITIVE ACTUATION OF NANOMEMBRANES AND DEVICES THEREFORE**

(71) Applicant: Max-Planck-Gesellschaft zur Förderung der Wissenschaften e.V., 80539 München (DE)
(72) Inventor: Weil, Tanja, 55124 Mainz (DE); Harvey, Sean, 55128 Mainz (DE); Marchesi D'Alvise, Tommaso, 55131 Mainz (DE); Synatschke, Christopher, 65187 Wiesbaden (DE); Fytas, Georg, 55118 Mainz (DE); Graczykowski, Bartolomiej, 62-020 Zalasewo (PL); Pochylski, Mikolaj, 60-682 Poznan (PL); Gapinski, Jacek, 60-651 Poznan (DE); Vasileiadis, Thomas, 60-687 Poznan (PL)
(74) Representative: v. Bezold & Partner Patentanwälte - PartG mbB

(57) **Abstract**

The present invention relates in a first aspect to a method for stimulus-sensitive actuation of nanomembranes made of or consisting of a stimulus-sensitive polymeric material, in particular polycatecholamine nanomembranes, comprising at least the following steps:
a) providing a stimulus-sensitive nanomembrane on a support;
b) exposing the nanomembrane to the stimulus for a predetermined time sufficient to induce a conformational change of said nanomembrane;
c) optionally inducing reversal of said conformational change by removing the stimulus; wherein the stimulus is selected from the group consisting of electric or magnetic fields, electromagnetic irradiation, in particular visible light, change of temperature, air pressure and/or change of humidity or moisture below or above a threshold level.

A further aspect of the invention relates to a device, in particular a nano- or microdevice, comprising at least the following components:
- a stimulus-sensitive nanomembrane;
- a support of a stimulus-insensitive material on which the nanomembrane is provided; means for exposing said stimulus-sensitive nanomembrane to a stimulus selected from the group consisting of electric or magnetic fields, electromagnetic irradiation, in particular visible light, change of temperature, air pressure and/or change of humidity or moisture below or above a threshold level.

In particular, said device may be selected from the group comprising sensors, valves, in particular light or moisture valves, micromanipulators, actuators for remote control, or artificial muscles.

In more specific embodiments of both aspects, the stimulus-sensitive polymeric material may represent a homopolymer or heteropolymer of monomers selected from catecholamines, in particular from the group comprising dopamine, L and D enantiomers of norepinephrine, L and D enantiomers of epinephrine, L and D enantiomers of 3,4-dihydroxyphenylalanine, and aminotyrosine.

## Description

### Background of the invention

The actuation of micro- and nanostructures remains one of the exciting challenges of nanotechnology due to the wealth of fundamental questions and potential applications in energy harvesting, robotics, sensing, biomedicine, and tunable metamaterials.

The most common approaches for effecting said actuation of micro- and nanostructures rely on photoactuation. Photoactuation utilizes conversion of light into motion through reversible chemical and physical processes. The advantage of light over electrical or mechanical stimuli is the remote and spatiotemporal control of the actuation.

To date, the vast majority of photoactuators employ photochemical or photothermal effects. In photochemical materials, light-activated molecular level transformations (e.g., cis-trans isomerization, ring-opening and ring-closing, bond exchange, cycloadditions) can lead to macroscopic changes of dimensions or shape. Light-induced heat in photothermal materials can result in positive or negative thermal expansion, phase transitions, or adsorption/desorption of molecules, which can be harnessed into motion. Typically, photothermal materials merge light-absorbing heaters (dyes, nanoparticles) with thermo-responsive matrices such as liquid crystal elastomers, hydrogels, or shape memory polymers (see, e.g., Naumov et al., Chem Rev. 115, 12440-1249 (2015); and Li et al., Adv. Mater 31, 1807333 (2019)). The search for photoresponsive materials for artificial muscles mimicking their natural counterparts faces several trade-offs between light-to-motion conversion efficiency, light wavelength, dynamics, biocompatibility, operational temperature and environment, flexibility, multifunctionality, simplicity, and price, to name a few.

Polydopamine (PDA) is known to have excellent photothermal properties over the entire visible spectrum and up to 400 K it remains structurally stable. This feature was utilized in photoactuators combining PDA heaters with thermo-responsive polymers (Tian et al., ACS Appl. Mater. Interfaces 10, 8307-8316 (2018) and Li et al., J. Mater. Chem. A 5, 6740-6746 (2017) or graphene oxide (Ji et al., Adv. Funct. Mater. 24, 5412-5419 (2014)).

However, these heterogeneous structures are bulk and accordingly slow, while PDA is only used to enhance light absorption but has not been reported to contribute to mechanical motion/actuation.

In view of this prior art, a main object underlying the present invention is the provision of improved means for stimulus-sensitive, in particular light-sensitive, actuation of micro- and nanostructures which overcome or considerably alleviate the drawbacks of the prior art in that they are widely applicable and efficient, allow a very fast actuation if desired, are biocompatible and can be a manufactured in a relatively simple and cost-efficient manner.

This main object is achieved according to the present invention by providing the actuation method according to claim 1 and the device according to claim 8. Both aspects involve the use of stimulus-sensitive nanomembranes made of specific polymeric materials, in particular polycatecholamines and structurally related polymers with photothermal properties. Additional aspects and preferred embodiments of the invention are the subject of further claims.

### Description of the invention

The method for stimulus-sensitive actuation of micro- and nanostructures according to claim 1 represents a method for stimulus-sensitive actuation of nanomembranes made of or consisting of a stimulus-sensitive polymeric material and comprises at least the following steps:
a) providing a stimulus-sensitive nanomembrane on a support;
b) exposing the nanomembrane to the stimulus for a predetermined time sufficient to induce a conformational change of said nanomembrane;
c) optionally inducing reversal of said conformational change by removing the stimulus;
   wherein the stimulus is selected from the group consisting of electric or magnetic fields, electromagnetic irradiation, in particular visible light, change of temperature, air pressure and/or change of humidity or moisture below or above a threshold level and
   wherein the stimulus-sensitive polymeric material represents a homopolymer or heteropolymer of monomers selected from the group of compounds having one of the following Formulae A-E

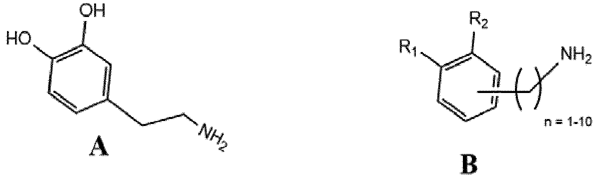

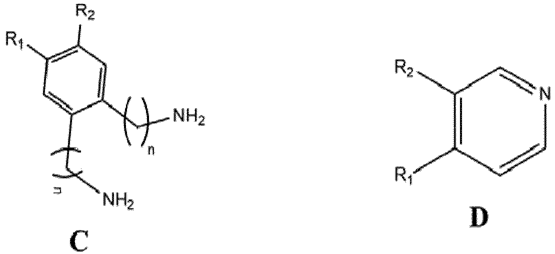

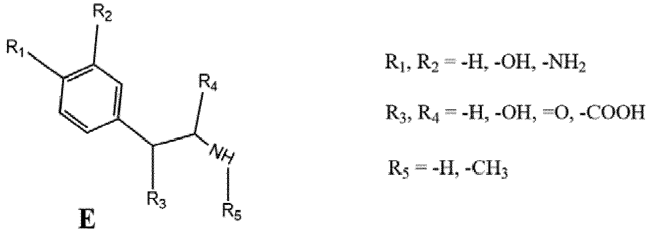

The duration of exposition to the stimulus may vary considerably depending on the respective specific stimulus and polymeric material and will be usually in the range from 10 ms to 24 h, preferably from 15 ms to 1 h. However, suitable and optimized exposition times in each case can be readily determined by the skilled artisan using routine experimentation.

In one preferred embodiment of the invention, the stimulus is visible light in a wavelength range from 405 to 780 nm. Typically, the visible light is monochromatic light but not limited thereto, in particular it is selected from the group comprising laser light and laser diode light. In the case of visible light as the stimulus, the exposition time will be typically in the range from 10 ms to 15 ms.

In an alternative preferred embodiment, the stimulus is a change of humidity or moisture below or above a threshold level on or in the vicinity of the nanomembranes. In this case, the exposition time may be in the range of 10 ms to 1 h, e.g. from 10 ms to 15 ms, from 10 ms to 1 s, from 1 s to 30 minutes or from 1 s to 60 minutes.

In another preferred embodiment, the stimulus-sensitive polymeric material represents a homopolymer or heteropolymer of monomers selected from catecholamines, in particular selected from the group comprising dopamine, norepinephrine (L and D enantiomer), 3,4-dihydroxyphenylalanine (Dopa), including L-Dopa and D-Dopa, epinephrine (L and D enantiomer) and aminotyrosine.

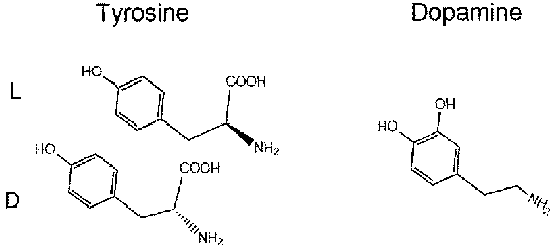

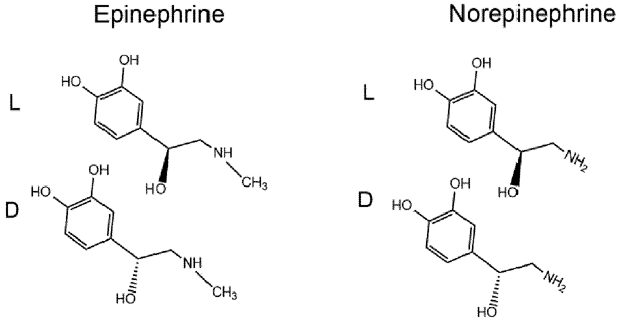

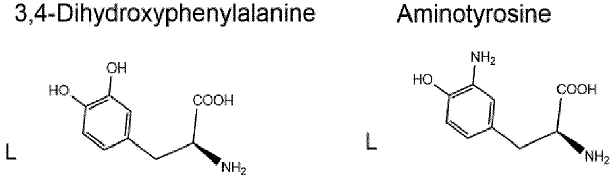

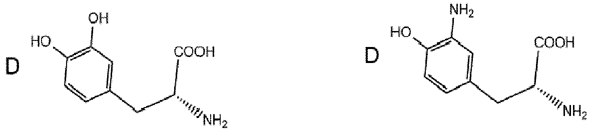

In a particularly preferred embodiment of the invention, the nanomembranes are polydopamine nanomembranes. The present inventors have i.a. shown that bare (i.e. without further constituents) PDA membranes exhibit very fast (sub-millisecond) contraction if triggered by red laser light, and spontaneous expansion in dark conditions.

Typically, the stimulus-sensitive nanomembrane has a thickness in the range from 5 to 100 nm, preferably from 10 to 20 nm.

The material for the support on which the stimulus-sensitive nanomembrane is provided is principally not especially limited. It may be any material capable to provide mechanical support for said nanomembrane and typically will be a stimulus-insensitive material.

In one specific embodiment, the support represents or comprises a membrane of a material which is insensitive to the stimulus and preferably has a thickness in the range from 10 nm to 200 nm, in particular from 20 nm to 100 nm.

More specifically, the material of the support may be selected from the group comprising Si₃N₄, silicon, ceramics, metals, including metal alloys, metal oxides, and organic polymers, such as insensitive, optionally hydrophobic polymer films, and the material of the support membrane may be selected from the group comprising Si₃N₄, silicon, ceramics, metals, including metal alloys, metal oxides, and organic polymers, such as insensitive, optionally hydrophobic polymer films.

In the case of a support membrane, one specific embodiment of the method according to the present invention comprises at least the following steps:
- illumination with visible light in order to induce a conformational change of the nanomembrane which involves bending or stretching of the bilayer comprising the nanomembrane and the support membrane and
- removal of the light stimulus which causes returning of the bilayer to its original shape.

Another specific embodiment of the method according to the present invention is characterized in that:
- a bilayer comprising the nanomembrane and the support membrane is provided on a barrier with one or more openings separating a first and a second humidity area with different degrees of humidity in such a manner that in the absence of stimulus the openings in the barrier are covered by the bilayer,
- the stimulus is a decrease of humidity in the second humidity area below a specific threshold level inducing a conformational change of the nanomembrane which involves bending of the bilayer comprising the nanomembrane and the support membrane and uncovering the openings in said barrier,
- increasing the humidity above said specific threshold level causes returning of the bilayer to its original flat shape and covering the openings in said barrier.

A second main aspect of the present invention relates to devices for stimulus-sensitive actuation of such nanomembranes as described above.

A device, in particular a nano- or microdevice, according to the present invention comprises at least the following components:
- a stimulus-sensitive nanomembrane;
- a support of a stimulus-insensitive material on which the nanomembrane is provided; means for exposing said stimulus-sensitive nanomembrane to a stimulus selected from the group consisting of electric or magnetic fields, electromagnetic irradiation, in particular visible light, change of temperature, air pressure and/or change of humidity or moisture below or above a threshold level,
wherein the nanomembrane is made or consists of a stimulus-sensitive polymeric material which represents a homopolymer or heteropolymer of monomers selected from the group of compounds having one of the following Formulae A-E

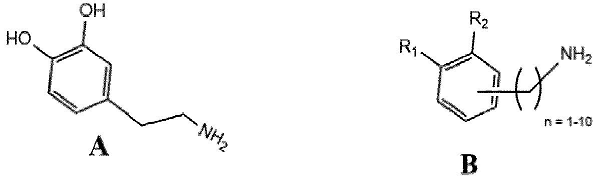

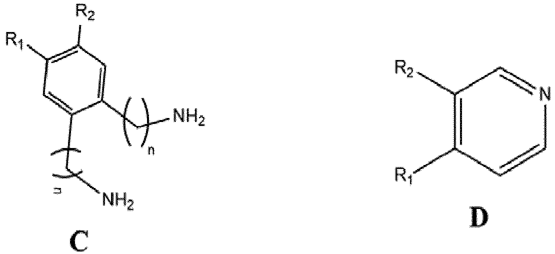

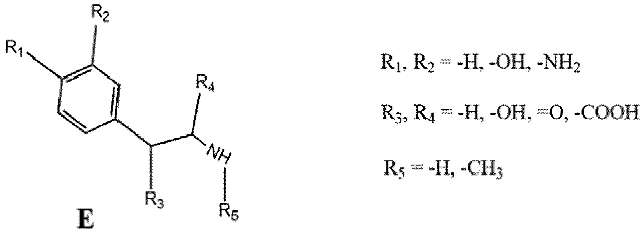

In one preferred embodiment of such a device, the means for exposing said stimulus-sensitive nanomembrane to a stimulus comprises a source of visible light in a wavelength range from 405 to 780 nm. Typically, the light is monochromatic light but not limited thereto, in particular it is selected from the group comprising laser light and laser diode light.

In an alternative preferred embodiment, the stimulus is a change of humidity or moisture below or above a threshold level on or in the vicinity of the nanomembranes.

In one preferred embodiment, the stimulus-sensitive polymeric material represents a homopolymer or heteropolymer of monomers selected from catecholamines, in particular selected from the group comprising dopamine, norepinephrine (L and D enantiomer), 3,4-dihydroxyphenylalanine (Dopa), including L-Dopa and D-Dopa, epinephrine (L and D enantiomer) and aminotyrosine.

In a particularly preferred embodiment of the invention, the nanomembranes are polydopamine nanomembranes. The present inventors have i.a. shown that that bare PDA membranes exhibit very fast (sub-millisecond) contraction if triggered by red laser light, and spontaneous expansion in dark conditions. This effect can be harnessed in bottom-up, soft-matter, ultrafast, nano- and micro-photoactuators.

Typically, the stimulus-sensitive nanomembrane has a thickness in the range from 5 to 100 nm, preferably from 10 to 20 nm.

The material for the support on which the stimulus-sensitive nanomembrane is provided is principally not especially limited. It may be any material capable to provide mechanical support for said nanomembrane and typically will be a stimulus-insensitive material.

In one specific embodiment, the support represents or comprises a membrane of a material which is insensitive to the stimulus and preferably has a thickness in the range from 10 nm to 200 nm, in particular from 20 nm to 100 nm.

In particular, the material of the support may be selected from the group comprising Si₃N₄, silicon, ceramics, metals, including metal alloys, metal oxides, and organic polymers, such as insensitive, optionally hydrophobic polymer films, and the material of the support membrane may be selected from the group comprising Si₃N₄, silicon, ceramics, metals, including metal alloys, metal oxides, and organic polymers, such as insensitive, optionally hydrophobic polymer films.

The devices of the present invention are suitable for a wide range of applications in the fields of energy harvesting, robotics, sensing, biomedicine, and tunable metamaterials, in particular photonic crystals (periodic dielectric structures which allow or forbid propagation of light (electromagnetic waves) at specific frequencies) or phononic crystals (periodic structures which allow or forbid propagation of acoustic waves/phonons at specific frequencies).

These devices may represent, e.g., sensors, valves, in particular light or moisture valves, micromanipulators, actuators for remote control, artificial muscles, or a component thereof.

In some specific embodiments of invention, the device is a valve or microactuator capable to switch between an off state and an on state by exposition to a light stimulus,
wherein in the off state the nanomembrane is in a relaxed conformation and incident light is either blocked or scattered diffusely by the nanomembrane,
and in the on state the nanomembrane is in a bent or stretched conformation and incident light can either pass next to the bent membrane or be reflected by the stretched membrane in a predetermined direction, e.g. towards a photodiode.

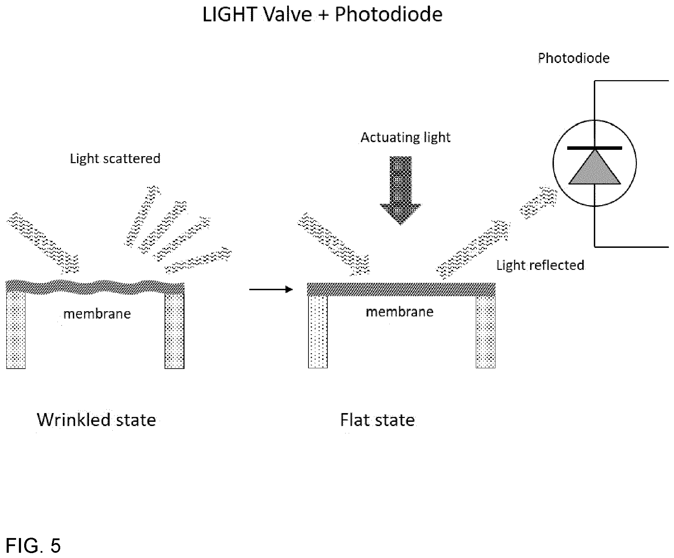

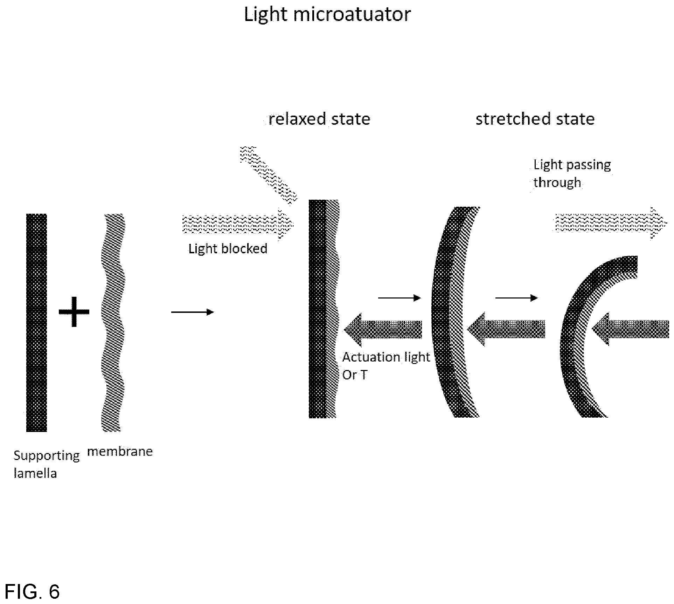

Two exemplary embodiments of such a light valve or micro-photoactuator, respectively, are schematically shown in Fig. 5 and 6.

In one more specific embodiment, the light valve comprises a bilayer lamella. One layer will be made of mechanically robust material, not photoactive material (e.g. a 20-100 nm thick Si₃N₄ membrane). The second layer, photoactive, will be made of PDA.
- The active part of the membrane (PDA) can switch between a flat (reflective) and a wrinkled (non-reflective/less-reflective) state, either by using moisture or through irradiation with an actuating light beam, which is oriented perpendicular to the membrane.
- The intensity of the reflected light arriving at the device at an angle other than 90 degrees, can be manipulated by switching the photoactive layer using the actuating light beam or moisture levels (high humidity = non-reflective; low humidity = reflective).
- When switching occurs using the actuating light beam, the response time of the system is extremely fast, in the range of several milliseconds.

In another more specific embodiment, the microactuator (photoactuator) comprises a bilayer lamella. One layer will be made of mechanically robust material, not photoactive material (e.g. a 20-100 nm thick Si₃N₄ membrane). The second layer, photoactive, will be made of PDA.
- The lamella exposed to light illumination (preferably laser diode light, laser, or a nonmonochromatic source of light) will bend (on state) due to PDA layer contraction due to temperature rise and water desorption.
- Removal of the light stimulus (off state) will return to the initial flat shape due to water sorption and mechanical relaxation.
- The device can operate at ambient atmospheric conditions (normal humidity, normal pressure and temperature from 10 to 30 °C).

In another specific embodiment of invention, the device is a micromanipulator and comprises at least
- a stimulus-sensitive nanomembrane suspended over a 10-100 µm diameter hole in a support frame of a stimulus-insensitive material, preferably a metallic, silicon or SiN frame;
- a light source;
wherein the nanomembrane has a star-shaped or cross-shaped form and the light source is adjustable to selectively illuminate one of the arms of said star-shaped or cross-shaped nanomembrane causing motion of the illuminated part of said membrane.

In a further specific embodiment of invention, the device is a valve capable to switch between an open state and a closed state and which comprises
- a first humidity area with a humidity above a predetermined threshold level,
- a second humidity area with an adjustable humidity level that is controlled to be either above, equal or below a predetermined threshold level,
- a barrier between the first and second humidity area with one or more openings,
- a bilayer of a stimulus-sensitive nanomembrane and a support membrane provided on said barrier,
wherein said bilayer is provided on the barrier in such a manner that in the closed state the openings in the barrier are covered by the bilayer and in the open state the openings are not covered by the bilayer due to a conformational change of the stimulus-sensitive nanomembrane induced by the stimulus.

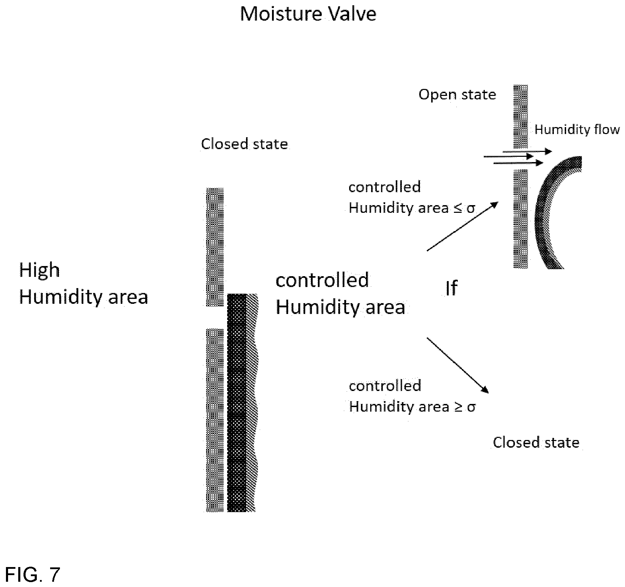

One exemplary embodiment of such a moisture valve is schematically shown in Fig. 7.

In another specific embodiment, the valve comprises a bilayer lamella. One layer will be made of mechanically robust material, not photoactive material (e.g. a 20-100 nm thick Si₃N₄ membrane). The second layer, photoactive, will be made of PDA.
- The active part of the membrane (PDA) is sensitive to moisture content. When the atmospheric moisture level drops, the lamella bends and opens the pores in the membrane. The pores allow diffusion of moisture from the reservoir on the non-active side (Si₃N₄).
- When the moisture level is sufficient, the lamella returns to the original flat shape, and the pores close. The moisture flow is stopped.

In still another specific embodiment of invention, the device is a valve capable to switch between an off or open state and an on or closed state and which comprises a stimulus-sensitive nanomembrane on a stimulus-insensitive support, wherein in the off state, in the absence of stimulus, the nanomembrane is in a relaxed conformation and water molecules can easily permeate the nanomembrane,
and in the on state, after exposition to a stimulus, the nanomembrane is in a stretched conformation and the membrane is less permeable or impermeable for water molecules.

The dimensions of a device according to the present invention may vary in a great extent, largely depending on the respective application and specific stimulus.

Typically, a micro- or nanodevice according to the invention has total dimensions (i.e. including the frame) in the x, y and z directions in the range of 1 - 50 mm, e.g. ca 10 x 10 mm (x and y directions) and 0.3 - 0.5 mm (z direction), respectively.

### Brief Description of the Figures

**Fig. 1** shows schematically the synthesis and structure of PDA membranes. **Fig. 1a****:** synthesis procedure and structure of PDA; **Fig. 1b****:** optical images of the PDA membrane and Si₃N₄ membrane grid covered with PDA film.
**Fig. 2** shows the motion of PDA films in response to light. **Fig. 2a****:** experimental setup for observation of light, temperature, or moisture-induced membranes actuation; **Fig. 2b**: response of the PDA membrane to illumination with the red light (30 mW); **Fig. 2c**: response of the PDA membrane to illumination with the red light of different intensities (50 mW and 60 mW).
**Fig. 3** shows the dynamics of laser-induced actuation of PDA membranes from time-resolved reflectivity measurements. **Fig. 3a**: principle for measuring the dynamics of wrinkles with time-resolved reflectivity of the membranes; **Fig. 3b****:** periodic contraction and flattening of an irradiated PDA membrane; **Fig. 3c**: left panel: time-trace of laser-driven contraction and flattening; right panel: Relaxation via swelling and wrinkling/buckling. **Fig. 3d****:** Fatigue testing of PDA films subjected to laser-induced contraction.

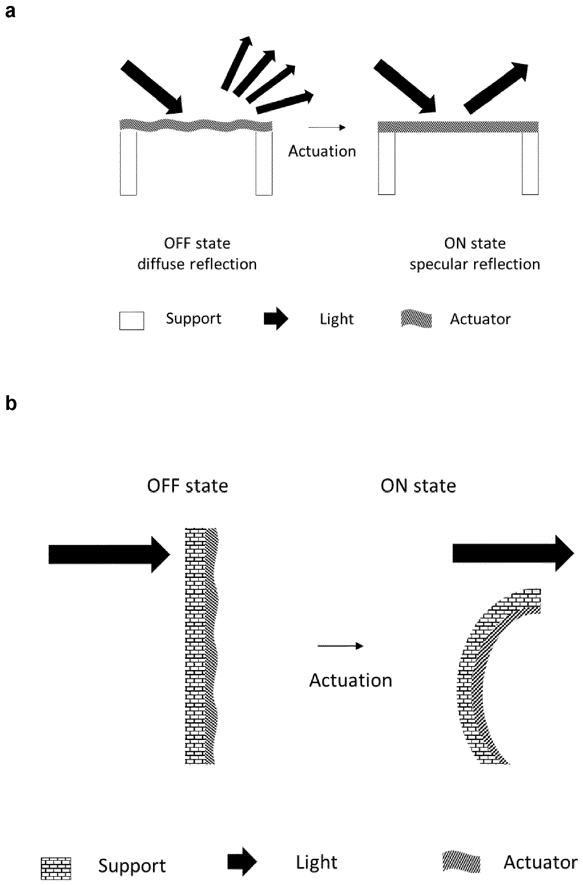

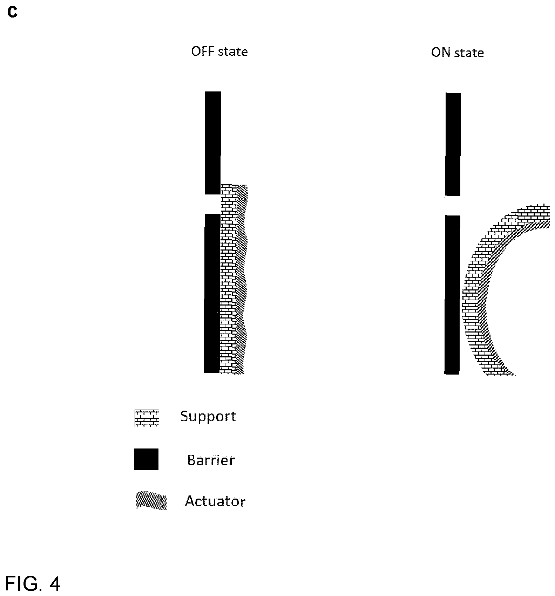

**Fig. 4** shows three principal arrangements of nanomembranes as utilized in various devices of the present invention.
**Fig. 5** schematically shows a device according to the invention which represents a light valve.
**Fig. 6** schematically shows a device according to the invention which represents a light microactuator.
**Fig. 7** schematically shows a device according to the invention which represents a moisture valve.

The following Examples are provided to illustrate the present invention in more detail, however, without limiting the same to the specific conditions and parameters thereof.

### EXAMPLE 1

### Preparation of ultra-thin polydopamine nanomembranes

PDA films with homogeneous surface roughness (ca 2.8 nm) and thickness of about 15 nm were prepared by electropolymerization as detailed below. The PDA films were polymerized on a gold electrode surface using cyclic voltammetry. The potential ranged between ±0.5 V at a slow scan rate of 2 mV/s. After incubation in a carbonate buffer to increase the cross-linking density, the film was desorbed from the gold surface through an electrochemical removal cycle and mechanically stripped from the surface using a sacrificial layer of polyvinyl alcohol (PVA). The film was transferred and suspended over circular holes (diameter from 20 to 80 µm) made in 1 µm thick Si₃N₄ membrane. After film transfer, the PVA layer was removed by dissolution in water.

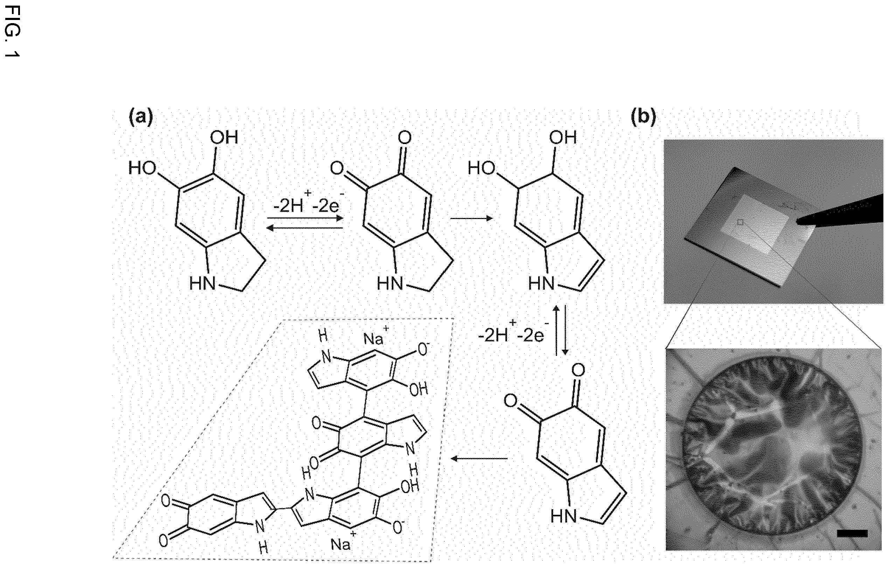

The relatively slow potential sweep during cyclic voltammetry favors the formation of a hydroxyl indole-like lamellar structure. Thus, the resulting ultrathin PDA is expected to contain short molecular segments held together by weaker intermolecular bonds and intercalated water molecules in the free volume that remains after cross-linking (Fig. 1a upper panel).

### Materials

Gold-coated (1000 Å) microscope slide (Sigma-Aldrich), were cut using a diamond tip. Phosphate buffer pH 7, 100 mM was prepared using sodium phosphate dibasic anhydrous (99%) and sodium phosphate monobasic (99%) (Sigma-Aldrich) in Milli-Q water. Carbonate buffer pH 10, 100 mM was prepared using sodium bicarbonate (>99.7%) and sodium carbonate (>99.8%) from Sigma-Aldrich, in Milli-Q water. Polyvinyl alcohol 80% hydrolyzed 9-10 kDa Mw (Sigma-Aldrich) was used to prepare the 10 wt% solution in Milli-Q water. Custom-made silicon nitride substrates were purchased from Silson.

### Method

Electropolymerization was performed using a Metrohm Autolab N series potentiostat (AUTOLAB PGSTAT 204) and a three-electrode configuration. A gold-covered glass microscope slide was used as the working electrode, a Ag/AgCI with 3M KCI as the reference electrode, and a gold wire as the counter electrode. All reactions were performed in a 30 mL electrochemical cell (Metrohm) filled with 25 mL of solution in air atmosphere and at room temperature. The working electrode was pre-treated for 10 minutes with Ar plasma at a pressure of 6 mbar. The gold substrate was immersed in a 1 mg/mL solution of dopamine hydrochloride dissolved in 100 mM phosphate buffer at pH 7.0 previously bubbled with nitrogen to remove oxygen from the solution and prevent dopamine self-polymerization. The film was then transferred either to silicon support for AFM measurements or to Si₃Ni₄ substrates for actuation through a previously established transfer method (Ji et al., Adv. Funct. Mater. 24, 5412-5419 (2019)). Briefly, polydopamine films were first incubated in carbonate buffer at pH 10 for 30 min before applying a removal cycle by sweeping the potential between -0.8 and +1.2 V for 3 cycles with a scan rate of 20 mV/s to desorb the film from the gold surface. The film was then covered with a polyvinyl alcohol (PVA) 80% hydrolyzed solution, 10% in water, and once dried, mechanically stripped off the surface and transferred onto the respective substrates. The PVA layer was subsequently removed by washing with water.

### EXAMPLE 2

### Stimulus-induced actuation of PDA membranes

The stimulus-induced, in particular laser light-induced, actuation of an ultra-thin polydopamine membrane prepared according to Example 1 was investigated.

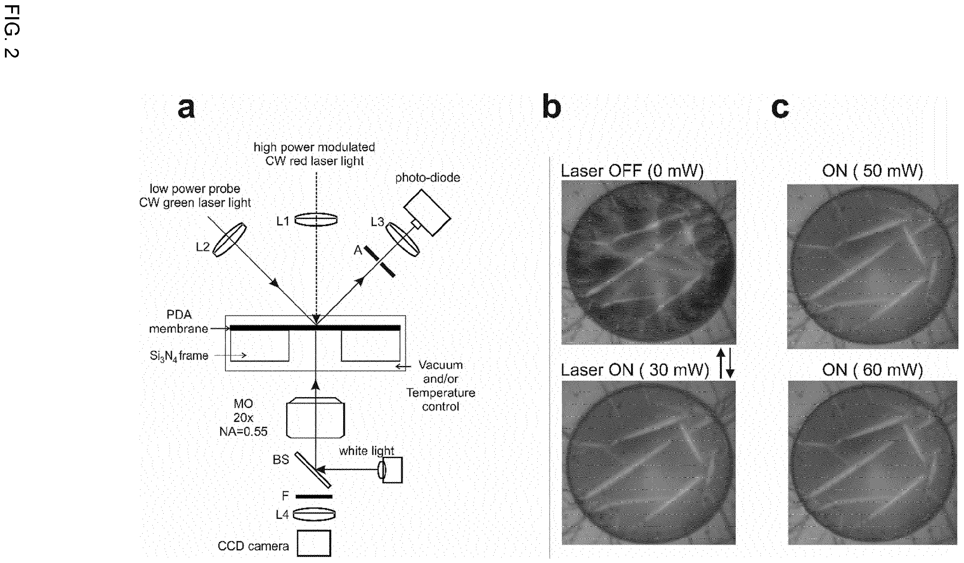

Fig. 2a schematically illustrates an experimental setup for observation of light, temperature, or moisture-induced membranes actuation based on two continuous-wave (CW) lasers. The sample is mounted in a temperature- and pressure-controlled microscope stage and illuminated with red (660 nm) laser light, which triggers the actuation. The laser light spot size approximately matches the membrane area. Low power green (532 nm) laser light is detected by the photodiode and probes the membrane reflectivity. The change of the membrane morphology is captured by a CCD camera. Symbols: L1, L2, L3, L4 - lenses, F - optical filter, BS - beamsplitter, A - aperture, MO - microscope objective, CW - continuous wave.

The out-of-plane deformation of the membrane was periodically stimulated by red laser light (660 nm), with the spot diameter matching the membrane size. The light power of the red laser was modulated using a square waveform signal (on-off keying) with varied frequency (1-100 Hz) and amplitude (10-100 mW). The mechanical response of the membrane was probed by low-power (< 1 mW) green laser light (532 nm) reflected from the membrane and detected by a photodiode. Simultaneously, the deformation of the membrane was observed by optical microscopy.

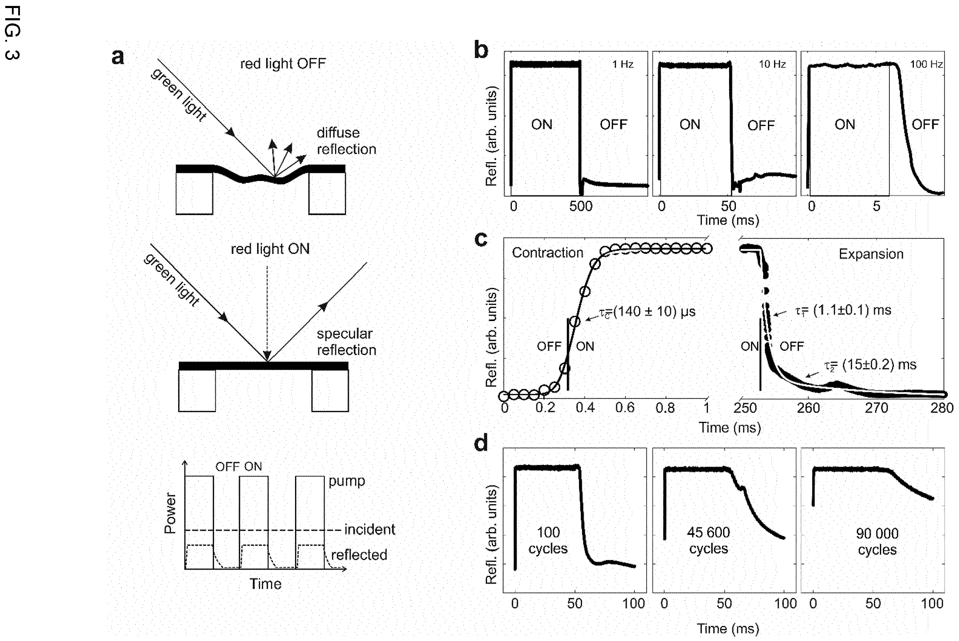

Fig. 3a depicts the principle for measuring the dynamics of wrinkles with time-resolved reflectivity of the membranes. Red laser light ON triggers the flattening of the membrane and specular reflection of the green light (middle panel), whereas the red laser OFF state corresponds to diffuse reflection of the green light (upper panel). In the lower panel, the "incident" and "reflected" intensities refer to the green light used to probe the membrane motions, and the red shaded areas mark the temporal intervals that the red pump laser is on. Initially (red laser OFF), the membranes were buckled with dense wrinkles resulting in diffuse reflection of the green probing light and suppressed photodiode signal. As further shown in e.g. Fig. 2, the membrane contracts and flattens when exposed to high power laser irradiation (red laser ON). This behavior results in specular reflection of the green laser light captured by the photodiode. The lower panel of Fig. 3a illustrates a schematic of the duty cycle of the pump laser, the sample response, and the time-evolving intensity of the reflected light from the membrane.

Fig. 3b shows optical images of a PDA membrane subjected to light-induced contraction at ambient conditions. The power of the incident red laser light is 30 mW (enabling a temperature rise of the membrane to about 370 K).

The flattening of the PDA membrane can also be induced by increasing the temperature. Optical images of the membranes captured at exemplary temperatures show that the wrinkles started vanishing at about 333 K, and the membrane was already flat at 343 K.

This process was fully reversible, i.e., cooling to room temperature returned the membrane surface to the initial buckled state. Hence, it can be concluded that the origin of the membrane contraction was not photochemical as the same effect was achieved by about 40 K rise above the ambient temperature. In fact, the red laser light absorbed by the membrane serves as a local heat source.

To elucidate PDA contraction and expansion dynamics, an experimental apparatus and approach as schematically depicted in Fig. 2a was used. Fig. 3b displays the membrane reflectivity as a function of time in response to three exemplary modulated (on-off keying) powers of the red laser light. The contraction and flattening of the membrane happened in sub-millisecond timescales (about 140 µs) after the laser is on (Fig. 3c left panel). The membrane remained flat as long as the driving laser light was on. Once the red light was off, the sample relaxed back to the buckled state with discernibly slower relaxation dynamics (lasting about 16 ms), as shown in the right panel of Fig. 3c. The slower and more complicated dynamics of the relaxation phase can be attributed to the heat dissipation process (convection and conduction), two-stage swelling (water adsorption and structural relaxation), and the emergence of mechanical instabilities (buckling) of the membrane. Fig. 3d shows fatigue testing of PDA films subjected to laser-induced contraction.

Notably, the observed dynamics were substantially faster than in prior studies on, e.g., NTE polymers (Shen et al., Nature Chem. 5, 1035-1041 (2013)), photochemical actuators (Lahikainen et al., Nat. Commun. 9, 4148 (2018)), and PDA-coated liquid crystal elastomers (Tian et al., ACS Appl. Mater. Interfaces 10, 8307-8316 (2018)) that demonstrated response times in the order of 100-1,000 s, 1-10 s, and 0.1 s, respectively.

## Claims

1. A method for stimulus-sensitive actuation of nanomembranes made of or consisting of a stimulus-sensitive polymeric material, in particular polycatecholamine nanomembranes, comprising at least the following steps:
a) providing a stimulus-sensitive nanomembrane on a support;
b) exposing the nanomembrane to the stimulus for a predetermined time sufficient to induce a conformational change of said nanomembrane;
c) optionally inducing reversal of said conformational change by removing the stimulus;
wherein the stimulus is selected from the group consisting of electric or magnetic fields, electromagnetic irradiation, in particular visible light, change of temperature, air pressure and/or change of humidity or moisture below or above a threshold level and
wherein the stimulus-sensitive polymeric material represents a homopolymer or heteropolymer of monomers selected from the group of compounds having one of the following Formulae A-E

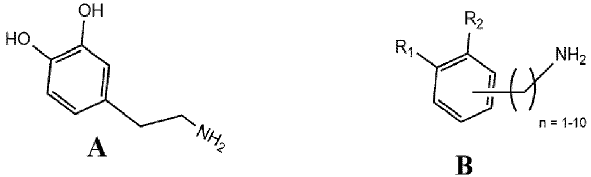

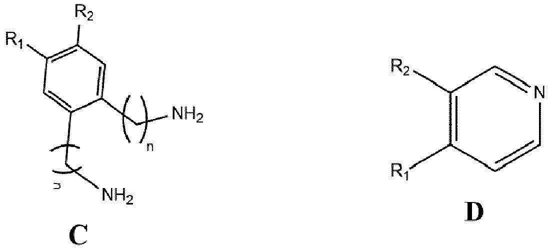

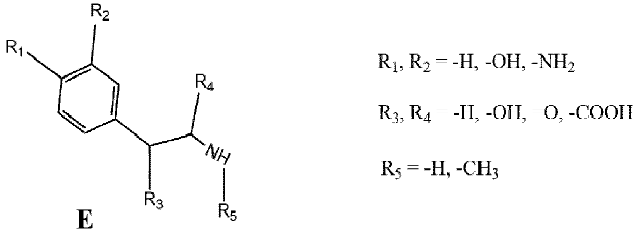

2. The method according to claim 1, wherein the stimulus is visible light in a wavelength range from 405 to 780 nm, in particular selected from the group comprising laser light and laser diode light.

3. The method according to claim 1 or 2, wherein the nanomembrane is exposed to the stimulus for a period of time in the range from 10 ms to 24 h, preferably from 15 ms to 1 h.

4. The method according to any one of claims 1 to 3, wherein the nanomembrane in the absence of stimulus is in a relaxed conformation and easily permeable for water molecules and after the conformational change induced by a stimulus the nanomembrane is in a stretched conformation and the nanomembrane is less permeable or impermeable for water molecules.

5. The method according to any one of claims 1 to 3, wherein the support represents or comprises a membrane of a material which is insensitive to the stimulus and preferably has a thickness in the range from 10 nm to 200 nm, in particular from 20 nm to 100 nm.

6. The method according to claim 5, wherein
- illumination with visible light induces a conformational change of the nanomembrane which involves bending or stretching of the bilayer comprising the nanomembrane and the support membrane and
- removal of the light stimulus causes returning of the bilayer to its original shape.

7. The method according to claim 5, wherein
- the bilayer comprising the nanomembrane and the support membrane is provided on a barrier with one or more openings separating a first and a second humidity area with different degrees of humidity in such a manner that in the absence of stimulus the openings in the barrier are covered by the bilayer,
- the stimulus is a decrease of humidity in the second humidity area below a specific threshold level inducing a conformational change of the nanomembrane which involves bending of the bilayer comprising the nanomembrane and the support membrane and uncovering the openings in said barrier,
- increasing the humidity above said specific threshold level causes returning of the bilayer to its original flat shape and covering the openings in said barrier.

8. A device, in particular a nano- or microdevice, comprising at least the following components:
- a stimulus-sensitive nanomembrane;
- a support of a stimulus-insensitive material on which the nanomembrane is provided; means for exposing said stimulus-sensitive nanomembrane to a stimulus selected from the group consisting of electric or magnetic fields, electromagnetic irradiation, in particular visible light, change of temperature, air pressure and/or change of humidity or moisture below or above a threshold level,
wherein the nanomembrane is made or consists of a stimulus-sensitive polymeric material which represents a homopolymer or heteropolymer of monomers selected from the group of compounds having one of the following Formulae A-E

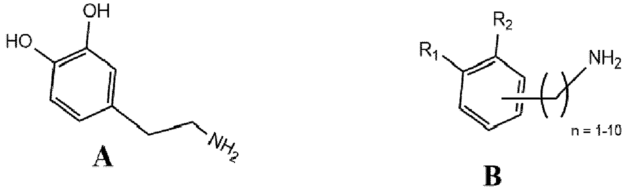

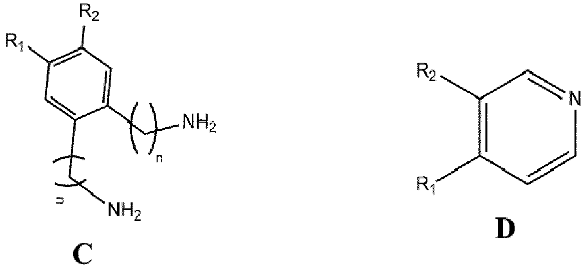

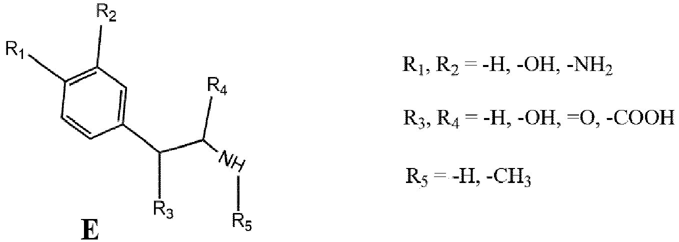

9. The device according to claim 8, which is selected from the group comprising sensors, valves, in particular light or moisture valves, micromanipulators, actuators for remote control, or artificial muscles.

10. The device according to claim 8 or 9, wherein the means for exposing said stimulus-sensitive nanomembrane to a stimulus comprises a source of visible light in a wave length range from 405 to 780 nm, in particular selected from the group comprising laser light and laser diode light.

11. The device according to any one of claims 8 to 10, wherein the support represents or comprises a membrane of a material which is insensitive to the stimulus and preferably has a thickness in the range from 10 nm to 200 nm, in particular from 20 nm to 100 nm.

12. The device according to any one of claims 8 to 11, which is a valve or microactuator capable to switch between an off state and an on state by exposition to a light stimulus,
wherein in the off state the nanomembrane is in a relaxed conformation and incident light is either blocked or scattered diffusely by the nanomembrane,
and in the on state the nanomembrane is in a bent or stretched conformation and incident light can either pass next the bent membrane or be reflected by the stretched membrane in a predetermined direction, e.g. towards a photodiode.

13. The device according to any one of claims 8 to 11, which is a micromanipulator and which comprises
- a stimulus-sensitive nanomembrane suspended over a 10-100 µm diameter hole in a support frame of a stimulus-insensitive material, preferably a metallic, silicon or SiN frame;
- a light source;
wherein the nanomembrane has a star-shaped or cross-shaped form and the light source is adjustable to selectively illuminate one of the arms of said star-shaped or cross-shaped nanomembrane causing motion of the illuminated part of said membrane.

14. The device according to any one of claims 8 to 10, which is a valve capable to switch between an open state and a closed state and which comprises
- a first humidity area with a humidity above a predetermined threshold level,
- a second humidity area with an adjustable humidity level that is controlled to be either above, equal or below a predetermined threshold level,
- a barrier between the first and second humidity area with one or more openings,
- a bilayer of a stimulus-sensitive nanomembrane and a support membrane provided on said barrier,
wherein said bilayer is provided on the barrier in such a manner that in the closed state the openings in the barrier are covered by the bilayer and in the open state the opening are not covered by the bilayer due to a conformational change of the stimulus-sensitive nanomembrane induced by the stimulus.

15. The device according to any one of claims 8 to 12, which is a valve capable to switch between an off or open state and an on or closed state and which comprises a stimulus-sensitive nanomembrane on a stimulus-insensitive support, wherein
in the off state, in the absence of stimulus, the nanomembrane is in a relaxed conformation and water molecules can easily permeate the nanomembrane,
and in the on state, after exposition to a stimulus, the nanomembrane is in a stretched conformation and the membrane is less permeable or impermeable for water molecules.

16. The method according to claim 5 or the device according to claim 11, wherein the material of the support membrane is selected from the group comprising Si₃N₄, silicon, metals, including metal alloys, metal oxides, ceramics and insensitive organic polymers.

17. The method or device according to any of claims 1 to 16, wherein the nanomembrane is made or consists of a stimulus-sensitive polymeric material which represents a homopolymer or heteropolymer of monomers selected from catecholamines, in particular from the group comprising dopamine, L and D enantiomers of norepinephrine, L and D enantiomers of epinephrine, L and D enantiomers of 3,4-dihydroxyphenylalanine, and aminotyrosine.

18. The method or device according to any of claims 1 to 17, wherein the nanomembrane is a polydopamine nanomembrane and/or has a thickness in the range from 5 to 100 nm, preferably from 10 to 20 nm.
